# EUROPEAN PATENT APPLICATION

(11) **EP 3 796 540 A1**
(43) Date of publication of application: **24.03.2021**
(21) Application number: 19197835.2
(22) Date of filing: 17.09.2019
(51) Int. Cl.: H02M 7/483, H02M 1/32, H01L 25/11, H02H 7/12, H02H 7/122, H02M 7/00, H05K 7/20, H02M 1/00

(54) **CELL FOR USE IN A CONVERTER**

(71) Applicant: Maschinenfabrik Reinhausen GmbH, 93059 Regensburg (DE)
(72) Inventor: BRYANT, Angus Toby, Oakington, CB24 3AU Cambridge (GB); KILPIN, Matthew, 7100 Vejle (DK)

(57) **Abstract**

The invention regards a cell for use in a Modular Multi-Level Converter, the cell comprising a half bridge or full bridge, which includes at least two transistors and an energy storage unit, the transistors being mounted to a heatsink and each cell further comprising a bypass switch to bypass the cell, characterized in that, the bypass switch is formed by at least one thyristor without an additional mechanical switch and the thyristor being coupled to said heatsink of the cell.

## Description

### Technical Field

The present invention generally relates to the field of voltage-source converters according to the principle of modular multilevel converters, to cells or modules used in such modular multilevel converters as well as to a respective method.

### Background

The modular multilevel converter is an electric power converter having multiple modules or cells which are connected in series. Each cell includes power semiconductors and an energy storage unit and acts as a half bridge or a full bridge connected to the energy storage unit. Usually, the energy storage unit is a capacitor. Typically, two chains of cells, called phase arms, are connected in series. The series connection of two phase arms is called a phase leg. The first phase arm of a phase leg may connect to the positive connection of a DC voltage and the second phase arm may connect to the negative connection of the DC voltage. The connection point between the two phase arms forms one AC voltage terminal. Normally, a modular multilevel converter consists of two or more phase arms corresponding to the phases of a multi-phase AC system. Such a converter converts single phase or multi-phase AC voltage into DC voltage and vice versa. For instance, three phase legs all connected to the DC voltage and having three AC voltage connections form a three phase converter for converting three phase voltage into DC voltage and vice versa.

Typically, modular multilevel converters are designed for converting three-phase voltages into DC voltages. Each cell of a series connection may be considered as a voltage source representing a voltage step on the AC side, which may be activated by controlling the respective power semiconductors. Thus, by controlling the semiconductors of all cells, the series connection of multiple cells can produce a desired voltage course (i.e. the AC voltage) as a step function. Controlling of the power semiconductors of the cells is performed in a manner that the voltage of the storage units is balanced. In addition, the voltage of each cell is usually the same. Thus, modular multilevel converters are able to convert AC voltages of different frequencies into DC voltages and vice versa, and further produce very small harmonics due to their fine-grained step functions.

The concept of using a plurality of serially connected cells enables modular multilevel converters to handle high voltages even if the particular power semiconductors of each cell only withstand a lower voltage. Therefore, multilevel converters are able to convert voltages of several hundreds of kilovolts.

Modular multilevel converters cover a wide spectrum of applications, such as high voltage power transmission, drive power conversion or load distribution.

Another advantage of modular multilevel converters is their fault tolerance. Each cell may include additional circuitry for bypassing the cell. In case of a malfunction, a faulting cell is bypassed so that the current of the converter (or more exactly, the current through a phase arm) is caused to bypass the respective cell. In order to use this bypass capability, a modular multilevel converter may include additional cells in order to ensure the required voltage strength also in the case that one or more cells are bypassed.

When a cell of a multilevel converter fails, the failing cell has to be shorted or bypassed, in order to keep the converter operating. Therefore, modular multilevel converters often include a bypass switch for each cell in order to allow current to bypass the cells in case of a failure or malfunction. For this, a technique for bypassing a failing cell in a very fast manner is necessary in order to protect the capacitor and the remaining power semiconductors of the cell. By bypassing a failing cell, significant subsequent damage to the rest of the converter can be avoided and operation of the converter can be continued without interruption.

A bypass switch is typically realized by using a combination of a thyristor and a mechanical contactor. In this combination, the mechanical switch operates on a long-term basis and has a very low contact resistance. However, after being activated, a mechanical switch typically takes several hundreds of milliseconds to close its mechanical contacts. However, a fast bypass procedure is required in case of a fault in order to protect the components of a cell. Therefore, in order to achieve a quick reaction in case of a fault, a thyristor additionally connected in parallel to the mechanical switch acts as a very fast bypass element having operation times of only a few microseconds. Thus, if the bypass switch is activated, the thyristor first applies its bypass capability. However, the thyristor has to carry the current only for a short amount of time until the contacts of the mechanical switch are closed as well. In order to allow fast reaction times of the bypass switch for both current directions, two anti-parallel connected thyristors or one thyristor together with an anti-parallel connected diode are used together with the mechanical switch, see EP 2 940 845 A1.

Alternatively, so-called pyrotechnic devices are used for providing the desired fast-acting bypass capability without requiring additional thyristors. However, such pyrotechnic devices can be used just once and for that reason have to be custom designed making them expensive, see EP 2 983 286 A1. A further approach is the use of fast vacuum interrupters as a mechanical switch, which is outlined for instance in DE 10 2007 018 344 A1. These switches also have to be custom-made and thus are expensive or can be subject to further trade restrictions (e.g. export controls).

As a third alternative for realizing fast-acting bypass capability according the prior art, special semiconductor switches within the cell may be used, which have the property of failing to short. However, such a solution requires particular semiconductors, such as integrated gate-commutated thyristors, IGCTs, that have much greater switching losses in comparison to IGBTs and that are significantly more expensive. In addition, semiconductors that fail to short may not be applied more than once, similar to the above pyrotechnic devices.

### Summary

The present invention provides a modular multilevel converter, MMC, comprising a plurality of legs or cells connected in series and for respective modules or cells as such, as well as for a respective method. A cell comprises a half bridge or a full bridge, which includes at least two transistors mounted to a heat sink as well as an energy storage unit, which may be a storage capacitor. Each cell further comprises a bypass switch to bypass the cell. The bypass switch is formed by at least one thyristor without an additional mechanical switch. The thyristor may be coupled to the same heatsink as the at least two transistors.

According to an aspect of the invention, the heatsink may be a coolant plate; the coolant plate may further be perfused by a coolant.

According to an aspect of the invention, the bypass switch may be formed by two antiparallel connected thyristors or one thyristor together with an antiparallel connected diode. One of the antiparallel thyristors or the antiparallel connected diode may be connected in parallel with a freewheel diode of a transistor of the half bridge.

According to an aspect of the invention, the thyristors and the diode of the bypass switch may be encapsulated by press-pack cases. In this case, the thyristors and/or the diode of the bypass switch may further be electrically connected to the heatsink or the coolant plate.

Mounting of the thyristors on the same heatsink as the at least two transistors may be performed in such a manner that the thyristors are mounted on the opposite side of the heatsink with respect to the transistors, thereby forming a barrier protecting the rest of the cell in case of an explosion of a transistor. A mechanical clamp structure may hold the thyristor, the two antiparallel connected thyristors or the thyristor and the diode onto the heatsink. The mechanical clamp structure may be designed so as to prevent mechanical tension of the mechanical clamp structure acting onto the heatsink.

The bypass switch may be activated in case of a failure of the cell. In addition, the bypass switch of the present invention may also be used for system testing or start-up (i.e. pre-charging of the storage capacitors) of the MMC. Furthermore, the bypass switch may be activated in further modes of operation of the MMC, in which only a reduced number of cells is required.

The transistors of the cell may be insulated bipolar transistors, IGBTs.

The present invention further provides a method for a modular multilevel converter, MMC, comprising multiple cells, the cells being connected in series to form at least one phase arm. Each cell of the converter may be formed either as a half bridge or as a full bridge, which includes at least two transistors and an energy storage unit, which may be a capacitor. Moreover, each cell comprises a bypass switch to allow current through the converter to bypass the cell. The bypass switch may be formed by one thyristor or two antiparallel connected thyristors, or by one thyristor and one diode connected in antiparallel. The method further comprises the steps of detecting a malfunction or failure of a cell; triggering or activating the one or two thyristors of said cell in order to allow current to bypass said cell; and keeping the one or two activated thyristors of the bypass switch in a conducting state in order to keep the MMC operating.

### Brief description of the drawings

The foregoing will be more readily understood from the following detailed description, in particular, when taken in conjunction with the drawings, in which:
**FIG. 1** is an equivalent circuit diagram of an electric power converter according to an embodiment based on the principle of the modular multilevel converter;
**FIG. 2** is a graph showing the stepped time course of the voltage produced by a modular multilevel converter;
**FIG. 3** is an equivalent circuit diagram of a cell in an electric power converter based on the principle of the modular multilevel converter, wherein the cell includes a half bridge and a mechanical bypass switch;
**FIG. 4** is an equivalent circuit diagram of a cell in an electric power converter based on the principle of the modular multilevel converter, wherein the cell includes a half bridge, a mechanical bypass switch, a thyristor and a diode;
**FIG. 5** is an equivalent circuit diagram of a cell in an electric power converter based on the principle of the modular multilevel converter according to an embodiment of the present invention;
**FIG. 6** is an equivalent circuit diagram of a cell in an electric power converter based on the principle of the modular multilevel converter according to another embodiment of the present invention;
**FIG. 7** is a conceptual layout of a cell according to an aspect of the present invention showing advantageous arrangements of components.

### Detailed Description

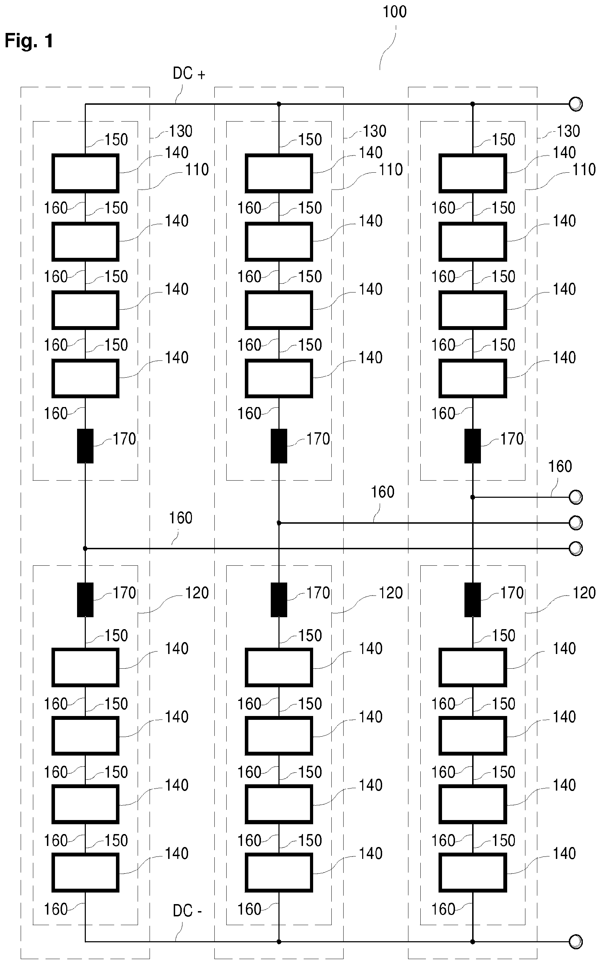

FIG. 1 shows a schematic circuit diagram of a modular multilevel converter (MMC) 100 for electric power conversion according to an embodiment of the present invention. The modular multilevel converter 100 includes one or more phase arms 110, 120. Each of the phase arms 110, 120 includes multiple cells 140, wherein each cell acts as electrical two-pole having two connection terminals 150, 160. The cells 140 of a phase arm 110, 120 are connected in series using their connection terminals 150, 160. Two phase arms 110, 120 connected in series form a phase leg 130. Each phase arm may further include an inductor 170. One phase arm 110 of a phase leg 130 connects to the positive connection of a DC voltage and the second phase arm 120 of the phase leg 130 connects to the negative connection of the DC voltage. Each of the phase legs 130 has an intermediate AC voltage terminal 160 at the connection point between the two phase arms 110, 120. For example, as shown in Fig. 1, a modular multilevel converter having three phase legs 130 has three AC voltage terminals 160 that are connected to the three electrical connections of a three phase network. However, other numbers of phases, such as one phase, two phase or more than three phases, requiring a respective number of phase legs 130 in parallel, are possible.

The modular multilevel converter 100 acts as a system for converting electric power from AC to DC and vice versa. Modular multilevel converters are used, for instance, in the technical equipment for transmitting high-voltage current and for flexible alternating current transmission system (FACTS) in AC applications. One major advantage of the modular multilevel converter 100 in comparison to other converter technologies is the fine-grained voltage course of the output voltage provided by the modular multilevel converter 100 at the AC voltage terminals 160. Moreover, the modular design of this converter type allows scalability in a wide range of power and voltage.

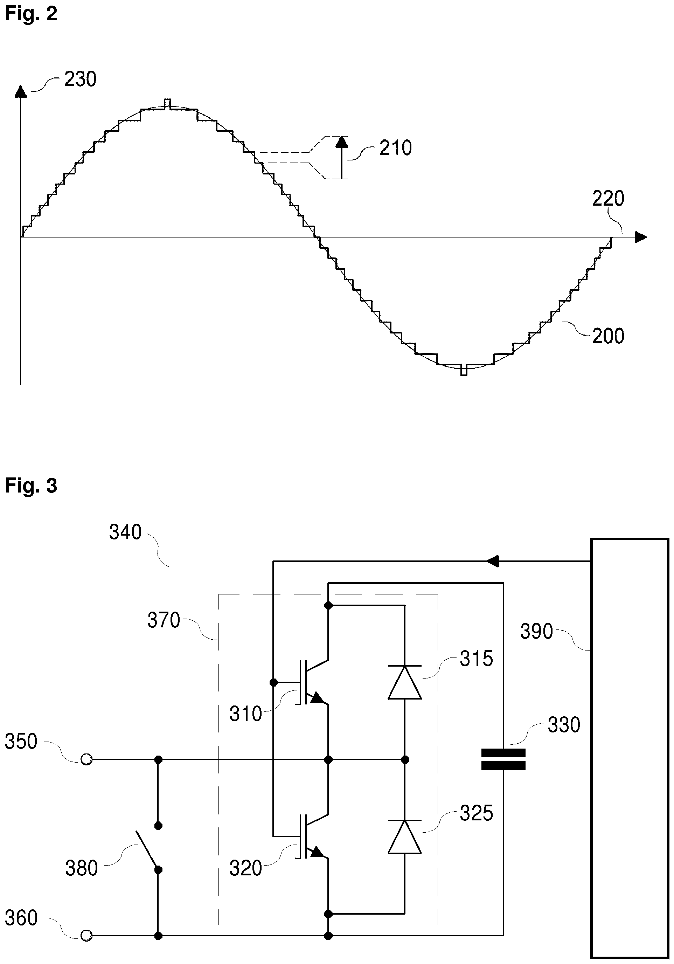

FIG. 2 shows an exemplary time course 200 of a sine wave voltage produced by a modular multilevel converter 100. The horizontal axis 220 corresponds to the time and the vertical axis 230 shows the voltage at an AC voltage terminal 160 of the converter. Each voltage step 210 of the voltage time course 200 corresponds to the voltage of one cell 140 that is switched from the active state to the bypass state or vice versa as further explained below. Therefore, in order to produce a time course having a number of voltage steps 210 that is fewer or equal to n, the converter requires n cells 140 in each phase arm 110, 120.

FIG. 3 is a circuit diagram of a cell 340 employed in a modular multilevel converter according to the prior art. The cell 340 according to Fig. 3 operates in two quadrants of voltage and current, processing positive voltage and positive or negative current at the connection terminals 350, 360. Each cell 340 comprises an energy storage unit 330. Typically, a storage capacitor is used as an energy storage unit 330. The cell 340 further includes at least two semiconductor switches 310, 320 connected in series. The semiconductor switches are turn-on/turn-off controlled. Transistors such as insulated bipolar transistors, IGBTs are preferably used as semiconductor switches 310, 320. The series connection of the two semiconductor switches forms a half bridge 370 having a high-side semiconductor switch 310 and a low-side semiconductor switch 320. The half bridge 370 of the cell being connected to the energy storage unit 330. Further, the power terminals of the low-side semiconductor switch 320 are connected to the connection terminals 350, 360 of the cell 340. Additionally, free-wheeling diodes 315, 325 are connected in parallel to the semiconductor switches 310, 320.

The cell 340 further includes a mechanical switching element 380 acting as a bypass switch. The mechanical switching element 380 is coupled to the connection terminals 350, 360 of the cell 340 in order to cause the phase current through a phase arm to bypass the cell 340 if the mechanical switching element 380 is in the conducting state. The bypass switch 380 may be used to bypass a cell 340 when the corresponding cell 340 fails. Bypassing a faulty cell 340 prevents the cell 340 from being exposed to overvoltage or overcurrent. Otherwise, if overvoltage or overcurrent were to occur in a cell, overloading the respective electric components may cause arcing or an explosion, leading to significant damage of the cell 340 or the converter. Thus, the bypass switch allows current to bypass the cell 340 in case of a cell failure or malfunction, and thus keep the converter operating. Accordingly, a modular multilevel converter may use additional cells for redundancy reasons. The mechanical switching element 380 may be an electrically-controlled mechanical switch or an electrically-controlled pyrotechnic switching device. In both cases, electrical contacts are closed if the mechanical switching element 380 is in the conducting state.

Moreover, a control unit 390 is used for controlling the semiconductor switches and the mechanical switching element 380 of the cell 340.

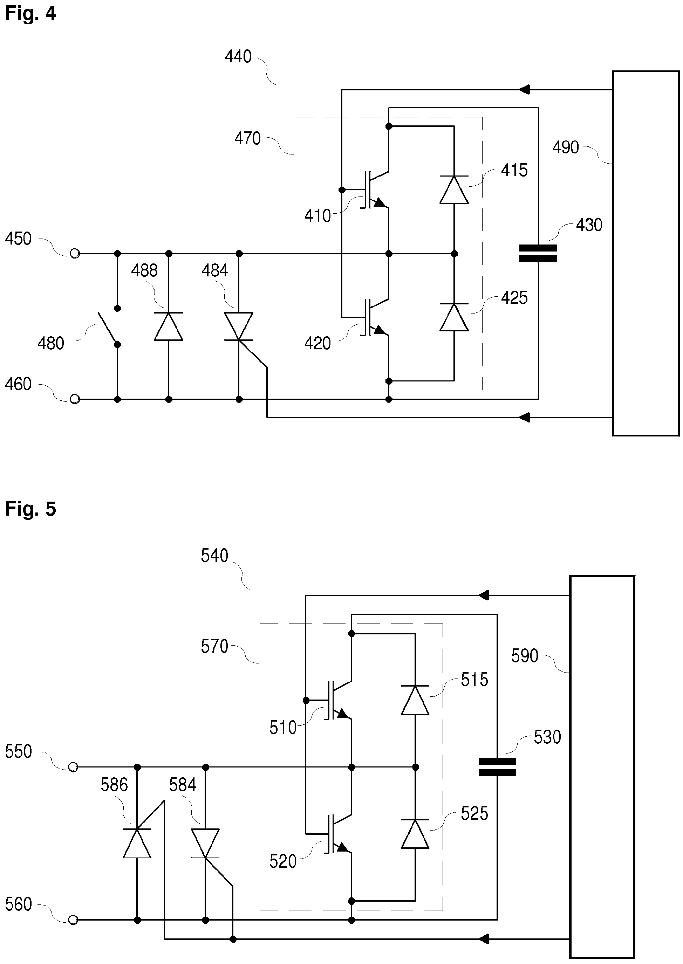

FIG. 4 is a further circuit diagram of a cell 440 employed in a modular multilevel converter according to the prior art, such as EP 2 940 845 A1. Additionally, to the storage capacitor 430, the two semiconductor switches 410, 420 with the free-wheeling diodes 415, 425 forming a half bridge 470 and the mechanical switching element 480, the circuit of the cell 440 includes a thyristor 484 connected in parallel to the mechanical switching element. Thereby, the anode of the thyristor 484 is connected to the positive connection terminal 450 and the cathode of the thyristor is connected to the negative connection terminal 460 of the cell 440. Optionally, an additional diode 488 is further connected in anti-parallel to the thyristor 484 in order to relieve the free-wheeling diode 425 of the low-side transistor 420 in case of high current under failure condition. The thyristor 484 also acts as an additional bypass switch, however, having a significantly faster operation time of a few microseconds in comparison to often more than 100 milliseconds required by the mechanical switch to transition into the conducting state. Therefore, in case of a fault, the thyristor 484 and the mechanical switch are both controlled to bypass the cell. In such a case, firstly, the thyristor 484 becomes conductive and carries the main part of the current. The mechanical contacts of the mechanical switch are closed a fraction of a second later due to their mechanical nature. After the contacts of the mechanical switch have been closed, the current flows through the mechanical switch, because the voltage drop of the mechanical contacts is much lower in comparison to the voltage drop of the thyristor 484. Accordingly, in the case of bypassing the cell, the thyristor carries the respective current only for a short time. The semiconductor switches 410, 420, the mechanical switching element 480 and the thyristor 484 are controlled by control unit 490.

FIG. 5 is a circuit diagram of a cell 540 in a modular multilevel converter according to a first embodiment of the present invention. The cell 540, may be one of a plurality of identical or similar cells that form a modular multilevel converter shown in Fig. 1. The cell 540 according to Fig. 5 includes at least two semiconductor switches 510, 520 connected in series and forming a half bridge 570. The half bridge has a high-side semiconductor switch 510 and a low-side semiconductor switch 520. The semiconductor switches are turn-on/turn-off controlled. Transistors, such as insulated bipolar transistors, IGBTs may be used as semiconductor switches 510, 520. Free-wheeling diodes 515, 525 may additionally act in parallel to the semiconductor switches 510, 520. The half bridge 570 of the cell being connected to the energy storage unit 530. A storage capacitor may be used as the energy storage unit 530. The half bridge of the cell 540 may operate in two quadrants of voltage and current, processing positive voltage and positive or negative current at the connection terminals 550, 560. The power terminals of the low-side semiconductor switch 520 are connected to the connection terminals 550, 560 of the cell 540. The cell 540 may comprises two antiparallel connected thyristors 584, 586 for bypassing the cell 540 without an additional mechanical switch or a pyrotechnic device in order to bypass the cell. The two antiparallel connected thyristors 584, 586 may be connected to the connection terminals 550, 560 of the cell 540. Moreover, a control unit 590 may be used for controlling the semiconductor switches 510, 520 and the thyristors 584, 586 of the cell 540.

According to a second embodiment of the present invention the circuit of Fig. 5 is, changed in that the thyristor 586 shown in Fig. 5 as being connected in parallel to the free-wheeling diode 525 of the low-side semiconductor switch 520 is replaced by a diode (not shown in Fig. 5). The diode replacing thyristor 586 does not have to be controlled by the control unit 590. Instead, for reverse current direction, the diode becomes conductive automatically and thus relieves the free-wheeling diode 525 of the low-side transistor 520.

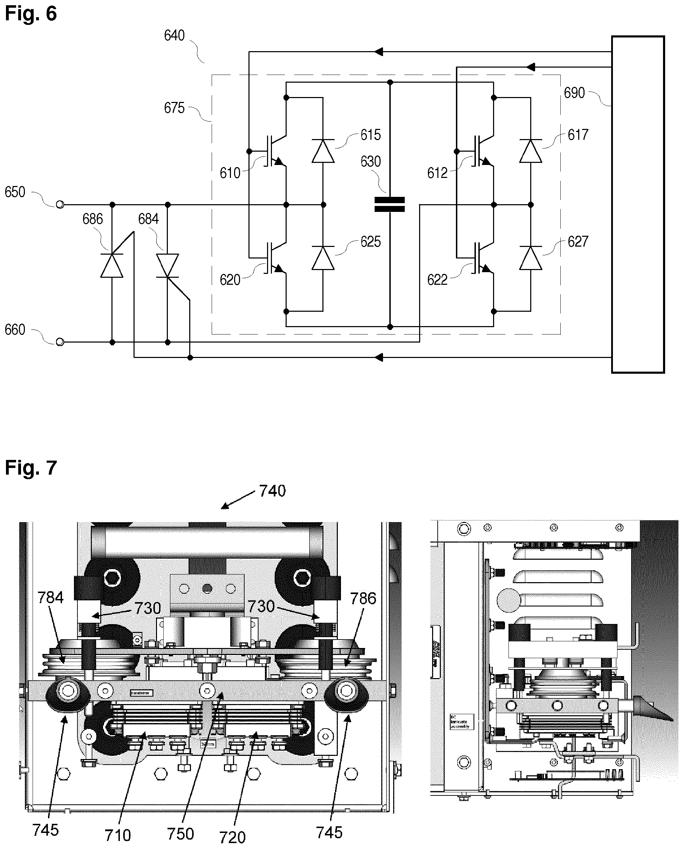

FIG. 6 is a circuit diagram of a cell 640 in a modular multilevel converter according to a third embodiment of the present invention. The cell 640, may be one of plurality of identical or similar cells that form a modular multilevel converter as shown in Fig. 1. In contrast to the cell shown in Fig. 5, the cell 640 includes a full bridge 675 that operates in four quadrants of voltage and current, processing positive and negative voltage as well as positive and negative current at the connection terminals 650, 660. The full bridge 675 includes at least four semiconductor switches 610, 612, 620, 622 and additional free-wheeling diodes 615, 617, 625, 627, as well as an energy storage unit 630. The full bridge 675 of the cell 640 may be considered as two half bridges connected in parallel. The first half bridge has the high-side semiconductor switch 610 and the low-side semiconductor switch 620 and the second half bridge has the high-side semiconductor switch 612 and the low-side semiconductor switch 622. The connection points of each of the two half bridges form the connection terminals 650 and 660 of the cell 640. Thus, the cell 640 of the full bridge 675 according to Fig. 6 is able to produce positive and negative voltages at the connection terminals 650, 660, additionally to the bypass state. However, in contrast to the cell shown in Fig. 4, the circuit of the third embodiment of the present invention comprises two antiparallel connected thyristors 684, 686 for bypassing the cell 640 without an additional mechanical switch or pyrotechnic device being required in order to bypass the cell. The two antiparallel connected thyristors 684, 686 are connected to the connection terminals 650, 660 of the cell 640. Moreover, a control unit 690 may be used for controlling the semiconductor switches 610, 612, 620, 622 and the thyristors 684, 686 of the cell 640.

All three embodiments shown and explained with respect to Fig. 5 and Fig. 6 may benefit from using a heatsink for cooling the transistors of the half bridge or full bridge, respectively. All transistors may be mounted to the same heatsink or coolant plate. The heatsink may further serve as electrical contact in order to electrically connect both thyristors or the thyristor and the diode. The thyristors may also be cooled by a heatsink. This heatsink may be the same as that for the transistors. Mounting of the thyristors onto the same heatsink as the transistors may be performed in such a manner that the thyristors are mounted on the opposite side of the heatsink with respect to the transistors, thereby forming a barrier protecting the rest of the cell in case of as explosion of a transistor. Moreover, the transistors of the cell may be insulated bipolar transistors, IGBTs.

The circuit topologies shown in Figures 5 and 6 are for illustration only. The present invention may be implemented by other circuit topologies having the same functionality.

FIG. 7 is a conceptual layout of the physical construction of a cell 740. The skilled person would understand that such a physical construction may greatly differ in accordance with practical needs and hence the shown physical construction is by way of example only and should not limit the present invention. On the other hand, Fig 7 shows some arrangement that may reveal advantageous arrangements of components according to the equivalent circuit diagram of Fig. 5 or 6 with a double-sided heatsink. Both the bypass thyristors 784, 786 and the IGBT modules 710, 720 are mounted on opposite sides of a heatsink 750. The heatsink may be used as an electrical terminal but either way it cools also the thyristors 784, 786 once activated. Thus, the heatsink 750 is able to cool all power devices, the IGBT modules 710, 720 as well as the bypass thyristors 784, 786. Therefore, only two coolant connections 745 are required for each cell. The clamp assembly 730 for the thyristors 784, 786 has to provide a high-pressure mechanical clamp to ensure adequate electrical contact (and also thermal contact), when the thyristors 784, 786 are encapsulated by press-packs. In spite of the high-pressure of the mechanical clamp, the clamp assembly for the thyristors may be implemented in such a manner that only small forces and tensions act on the heatsink or coolant plate.

The present invention further comprises a method for controlling a modular multilevel converter, MMC, comprising multiple cells. Each cell acts as an electrical two-pole having two connection terminals. Using their connection terminals, a plurality of cells may be connected in series to form a phase arm. Two phase arms may be connected in series to form a phase leg. One or more phase arms or phase legs form the modular multilevel converter. Moreover, each cell of the converter may be carried out either as a half bridge or as a full bridge, which includes at least two transistors and a storage capacitor. In addition, each cell further comprises a bypass switch that allows current through the converter to bypass the respective cell. The bypass switch may be formed either by one thyristor or two antiparallel connected thyristors, or by one thyristor and one diode connected in antiparallel. The method allows triggering or activating the one or two thyristors of said cell in order to allow current to bypass said cell were to be detected. Preferably, the bypass switch is closed if a malfunction or failure of the respective cell. Closing the bypass switch causes current to bypass said cell and thus keep the MMC operating.

Accordingly, the bypass thyristor is not only used for the short term, but is also able to carry the bypass current as a steady-state current. The advantage of using only thyristors as bypass switches instead of employing an additional mechanical switch is that they are fast, re-useable and wear-free (i.e. the thyristors are able to close repeatedly). Therefore, a bypass switch realized in this manner, i.e. without requiring a mechanical contactor, may additionally be used to bypass MMC-cells during specific operation modes of a MMC. These operation modes can include testing of a MMC or the start-up procedure of a MMC including pre-charging of the storage capacitors. In addition, also operation modes of a MMC in which certain cells are bypassed deliberately (e.g. due to the fact that not all cells are needed or to minimize aging and wear of the cells), can be easily implemented. Furthermore, requiring no mechanical contactor allows significant cost and space savings.

In the case of using thyristors for carrying steady-state current, cooling of the thyristors becomes an important issue. This is because the heat losses of thyristors may be in a similar range to the losses of the transistors used for forming the half bridge or full bridge, respectively (even though the forward voltage drop of a thyristor may be lower in comparison to IGBT modules that may be used as transistors). Therefore, using thyristors in this way would require an extra heatsink/cooling arrangement. Accordingly, respective cell components would require separate cooling plates for thyristor and clamp assembly. Moreover, cooling plates in a thyristor clamp assembly would require extra coolant connections, possibly causing reliability concerns (for instance an increased chance of leaks). In this regard, it is advantageous to mount the thyristors (or the thyristor and the diode) of the bypass switch on the same heatsink as the transistors of the cell. In the case that the heatsink is a coolant plate perfused by a coolant liquid, the number of coolant connections in the cell may be minimized by this concept. Accordingly, cooling of the respective components of cell may be performed in a space-efficient compact manner.

According to an aspect of the present invention, the heatsink, shared by the transistors and the thyristors (and optionally also the diode instead of a second thyristor) may be used as an electrical terminal, but either way it cools the thyristor in case of activation.

In most scenarios, using a bypass thyristor for carrying steady-state current requires bi-directional current to be supported. Therefore, two thyristors are used connected in anti-parallel (analogous to a triac). Alternatively, and for multilevel converter cells using a half bridge, one thyristor may be used together with a diode, which may be connected in antiparallel. In this case, the diode may be switched in parallel to the free-wheeling diode of the low-side transistor of the cell and takes the major part of the current from the opposite direction and thus relieves the free-wheeling diode of the low-side transistor.

The thyristors may be encapsulated by press-packs. This is an appropriate approach for thyristors having a respective current load capacity as required for a bypass switch. However, press-packs require a high-pressure mechanical clamp to ensure adequate electrical contact and also thermal contact.

Making dual use of the heatsink may further allow the thyristors to be mounted on the back of the heatsink (i.e. opposite side from the IGBT modules) to give containment if the IGBTs explode as a consequence of a fault. In this way, the heatsink forms a barrier protecting the rest of cell from debris and consequential damage.

Further, a mechanical clamp structure may hold the thyristor on to the heatsink, if highly-stressed heatsink threads or flatness (bowing) are not feasible.

The above considerations may result in a more compact design than a bypass thyristor assembly that is separate from the main IGBT heatsink. It may also result in a minimum number of coolant connections being required. Only one pair of coolant connections per cell may be required. It may allow thyristors to be used as the basis for the bypass switch (more readily available than compact mechanical contacts or pyrotechnic devices). This may allow the bypass to be turned on and off easily, which may not be the case for the alternative bypass switch designs. Thyristors are fast (<10 µs turn-on time) and re-useable. If the thyristor is mounted on the back of the heatsink, on the opposite side from the transistors, it may result in an explosion-proof design. The use of only one heatsink per cell (instead of one heatsink plus thyristor cooling plates) may result in a lower cell cost than using a separate thyristor clamp.

The terms and expressions employed herein are used as terms and expressions of description and not of limitation, and there is no intention, in the use of such terms and expressions, of excluding any equivalents of the features shown and described or portions thereof. In addition, having described a particular embodiment of the invention, it will be apparent to those ordinary skilled in the art that other embodiments incorporating the concepts disclosed herein may be used without departing from the spirit and scope of the invention. Accordingly, the described embodiments are to be considered in all respects only illustrative and not restrictive.

## Claims

1. Cell for use in a Modular Multi-Level Converter, MMC, the cell comprising a half bridge or full bridge, which includes at least two transistors and an energy storage unit, the transistors being mounted to a heatsink and each cell further comprising a bypass switch to bypass the cell,
**characterized in that**, the bypass switch is formed by at least one thyristor without an additional mechanical switch and the thyristor being coupled to said heatsink of the cell.

2. The cell of claim 1, wherein the cell is a half bridge comprising two transistors in series and the energy storage unit is a storage capacitor.

3. The cell of claim 1, wherein the cell is a full bridge comprising two series connections of two transistors and the energy storage unit is a storage capacitor.

4. The cell of any one of claims 1 to 3, wherein the bypass switch comprises two antiparallel connected thyristors.

5. The cell of claim 4, wherein one of the two antiparallel connected thyristors is in parallel to a freewheel diode of one of the at least two transistors for protecting said freewheel diode.

6. The cell of any one of claims 1 to 5, wherein the one or two thyristors are encapsulated by press-pack cases.

7. The cell of any one of claims 1 to 6, wherein the heatsink is a coolant plate.

8. The cell of claim 7, wherein the one or two thyristors are electrically connected to the coolant plate by their press-pack cases.

9. The cell of one of claims 7 or 8, wherein the transistors are mounted on one side of the coolant plate and the thyristor or the two antiparallel connected thyristors are mounted on the opposite side of the heatsink.

10. The cell of claim 9, wherein the heatsink forms a barrier protecting the rest of the cell in case of explosion of a transistor.

11. The cell of any one of claims 1 to 10, wherein the bypass switch is activated in case of a cell failure or malfunction, in order to allow current to bypass the cell.

12. The cell of any one of claims 1 to 11, wherein the transistors are insulated-gate bipolar transistors, IGBTs.

13. The cell of any one of claims 1 to 12, wherein a mechanical clamp structure holds the one thyristor or the two antiparallel connected thyristors on the heatsink.

14. The cell of claim 13, wherein the mechanical clamp structure is designed to prevent mechanical tension of the mechanical clamp structure acting on the heatsink.

15. Modular Multi-Level Converter, MMC, comprising multiple cells according to any one of claims 1 to 14, the cells being connected in series to form at least one phase arm.

16. The MMC of claim 15, comprising two phase arms connected in series forming a phase leg, the phase leg being connected to DC voltage and the connection point between the two phase arms being connected to AC voltage.

17. The MMC of claim 16, comprising three phase legs connected in parallel, each connection point of the three phase legs being connected to one phase of a three-phase network, respectively.

18. The MMC of any one of claims 15 to 17, wherein each phase arm has a at least two active cells and at least one redundant cell which is in standby condition with an activated bypass switch in order to allow current to bypass the cell, the redundant cell not contributing to the output voltage during normal operation, wherein activating the bypass switch is performed by triggering or activating the one or two thyristors and wherein the at least one redundant cell replaces the functionality of at least one active cell in case of a malfunction of said at least one active cell.

19. Method for a Modular Multi-Level Converter, MMC, comprising multiple cells, the cells being connected in series to form at least one phase arm, each cell comprising a half bridge or full bridge, which includes at least two transistors and a storage capacitor and each cell further comprising a bypass switch to bypass the cell, wherein the bypass switch is formed by one thyristor or two antiparallel connected thyristors, the method comprising:
detecting an operational mode of a cell;
triggering or activating the one or two thyristors of said cell in order to allow current to bypass said cell; and
keeping the one or two activated thyristors in conducting state in order to operate the MMC.

20. Method of claim 19, wherein the operational mode of a cell comprises
- a malfunction or failure of a cell and/or
- a testing procedure of the MMC and/or
- a start-up procedure of the MMC and/or
- operating the MMC with reduced number of cells to minimize aging.
